(19) Europäisches Patentamt
European Patent Office
Office européen des brevets

(11) **EP 3 523 644 B1**

(12) **FASCICULE DE BREVET EUROPEEN**

(45) Date de publication et mention
de la délivrance du brevet:
**05.05.2021 Bulletin 2021/18**

(21) Numéro de dépôt: **17780509.0**

(22) Date de dépôt: **26.09.2017**

(51) Int Cl.:
*G01N 29/02* (2006.01)   *B06B 1/02* (2006.01)
*G01H 13/00* (2006.01)   *G01N 29/036* (2006.01)
*G01N 29/24* (2006.01)   *G01N 29/32* (2006.01)
*G01N 21/17* (2006.01)   *H03B 5/32* (2006.01)
*H03H 9/24* (2006.01)

(86) Numéro de dépôt international:
**PCT/FR2017/052583**

(87) Numéro de publication internationale:
**WO 2018/065696 (12.04.2018 Gazette 2018/15)**

(54) **DÉTECTEUR DE GAZ ET PROCÈDE DE MESURE D'UNE CONCENTRATION GAZEUSE PAR L'EFFET PHOTO-ACOUSTIQUE**

GASDETEKTOR UND VERFAHREN ZUR MESSUNG EINER GASKONZENTRATION DURCH DEN PHOTOAKUSTISCHEN EFFEKT

GAS DETECTOR AND METHOD FOR MEASURING A GAS CONCENTRATION USING PHOTOACOUSTIC EFFECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.10.2016 FR 1659557**

(43) Date de publication de la demande:
**14.08.2019 Bulletin 2019/33**

(73) Titulaire: **Office National d'Etudes et de Recherches Aérospatiales 91120 Palaiseau (FR)**

(72) Inventeurs:
• **LEVY, Raphael**
  **92240 Malakoff (FR)**
• **AOUST, Guillaume**
  **43300 Arcons d'Allier (FR)**
• **VERLHAC, Béatrice**
  **92130 Issy les Moulineaux (FR)**
• **GUERARD, Jean**
  **91260 Juvisy-sur-Orge (FR)**
• **LE TRAON, Olivier**
  **91430 Vauhallan (FR)**
• **GAUDINEAU, Vincent**
  **91120 Palaiseau (FR)**

(74) Mandataire: **Plasseraud IP**
  **66, rue de la Chaussée d'Antin**
  **75440 Paris Cedex 09 (FR)**

(56) Documents cités:
**WO-A1-2009/109897     US-A1- 2011 179 872**

• **LI MO ET AL: "Extended Bandwidth Lorentz Force Magnetometer Based on Quadrature Frequency Modulation", JOURNAL OF MICROELECTROMECHANICAL SYSTEMS, IEEE SERVICE CENTER, US, vol. 24, no. 2, 1 avril 2015 (2015-04-01), pages 333-342, XP011577302, ISSN: 1057-7157, DOI: 10.1109/JMEMS.2014.2330055 [extrait le 2015-03-31] cité dans la demande**

EP 3 523 644 B1

**Description**

La présente invention concerne un détecteur de gaz et un procédé de mesure d'une concentration gazeuse. Elle concerne notamment un détecteur de gaz et un procédé de mesure d'une concentration gazeuse qui utilisent un effet photo-acoustique.

L'effet photo-acoustique est basé sur la capacité d'un gaz à absorber un rayonnement électromagnétique, qui peut être produit par exemple par un laser, et à évacuer l'énergie ainsi absorbée sous forme de chaleur. Lorsque l'absorption du rayonnement électromagnétique est intermittente et périodique, l'émission de chaleur engendre une onde acoustique dont l'intensité est représentative de la concentration du gaz.

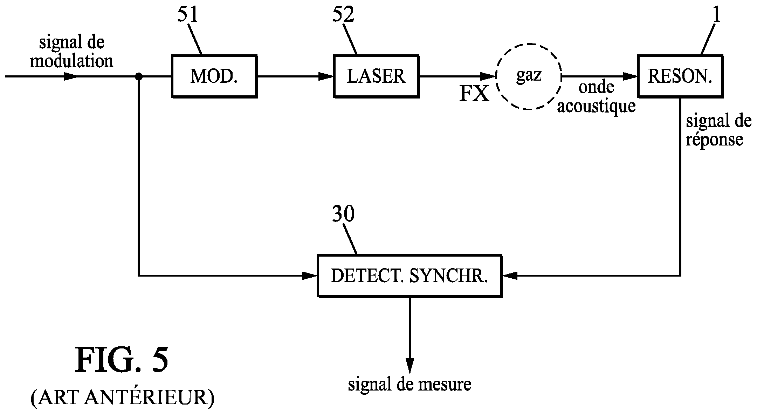

Il est alors connu de détecter l'intensité de l'onde acoustique en utilisant un résonateur électromécanique qui est sensible à cette onde acoustique, et qui est disposé à proximité du trajet du rayonnement électromagnétique dans le gaz. Un résonateur électromécanique qui est couramment utilisé dans ce but est par exemple un diapason en quartz, disposé pour recevoir l'onde acoustique sur l'une au moins de ses branches. La puissance du rayonnement électromagnétique est alors modulée à la fréquence propre de vibration du résonateur électromécanique, par un signal externe de modulation, ou bien la longueur d'onde du rayonnement électromagnétique est modulée par un signal externe de modulation à la moitié de la fréquence propre de vibration du résonateur, ainsi qu'il est décrit dans le document US 7,245,380. Grâce à l'excitation du résonateur qui est ainsi produite selon l'un de ses modes propres de vibration, la détection de l'intensité de l'onde acoustique à travers l'amplitude de vibration du résonateur présente une sensibilité qui est élevée. Enfin, l'amplitude de vibration du résonateur est mesurée en utilisant une détection synchrone entre un signal de réponse du résonateur et le signal externe de modulation du rayonnement électromagnétique. La figure 5 illustre l'architecture d'un tel détecteur de gaz connu de l'art antérieur. Il s'agit d'une architecture en boucle ouverte qui est alimentée en entrée par le signal externe de modulation, et qui comprend dans l'ordre : un modulateur 51 noté MOD., une unité laser 52 pour produire un faisceau de rayonnement électromagnétique FX qui est dirigé vers le gaz, et un résonateur électromécanique 1 noté RESON. qui est sensible à l'onde acoustique et produit un signal de réponse représentatif de l'intensité de cette onde acoustique. Le détecteur synchrone 30, noté DETECT. SYNCHR., reçoit simultanément le signal externe de modulation et le signal de réponse, et génère un signal de mesure continu dont l'amplitude est représentative de la concentration du gaz qui absorbe le rayonnement du faisceau FX.

Mais pour mesurer la concentration du gaz selon ce principe, il est nécessaire que la durée d'acquisition prévue pour une mesure soit supérieure à la durée d'établissement de la vibration dans le résonateur, cette dernière durée étant égale à $Q/f_r$, où $Q$ et $f_r$ sont respectivement le facteur de qualité et la fréquence propre de vibration du résonateur. Or pour obtenir une sensibilité de détection qui est élevée, le résonateur est sélectionné pour présenter une valeur du facteur de qualité $Q$ qui est importante, et une valeur de sa fréquence propre de vibration $f_r$ qui est basse. La durée d'acquisition pour une mesure est alors longue. En outre, étant donné que l'excitation du résonateur n'est pas asservie à sa fréquence propre de vibration, et celle-ci variant en fonction de conditions externes telles que la pression et la température ambiantes, il est nécessaire de répéter plusieurs acquisitions pour une mesure en variant la fréquence du signal externe de modulation jusqu'à ce qu'elle coïncide avec la fréquence propre de vibration du résonateur. La durée de mesure est ainsi multipliée par le nombre des acquisitions qui sont effectuées, aboutissant à une durée totale pour une seule mesure qui peut être de l'ordre de ou supérieure à quelques dizaines de secondes. Une telle durée peut être incompatible avec des exigences pratiques, notamment lorsque la pression et la température ambiantes sont susceptibles de varier rapidement, ou lorsque l'application impose une détection rapide, par exemple pour détecter une présence de gaz toxique, ou encore lorsque le détecteur est utilisé cycliquement pour plusieurs gaz différents.

Par ailleurs, il est aussi connu de mesurer un champ magnétique en utilisant un résonateur électromécanique, par exemple une poutre vibrante, qui est incorporé dans un oscillateur. De cette façon, la fréquence d'excitation du résonateur est asservie à la fréquence de résonance de l'oscillateur. Le résonateur est en outre soumis à une force de Lorentz qui résulte de l'interaction du champ magnétique à mesurer avec un courant électrique qui circule dans ce résonateur. Ce courant est obtenu à partir d'un signal d'excitation du résonateur, par application d'un déphasage fixe et amplification éventuelle. Un tel principe de mesure du champ magnétique est décrit dans l'article de Li M., Sonmezoglu S. et Horsley D., intitulé «Extended bandwidth Lorentz force magnetometer based on quadrature frequency modulation», Journal of Microelectromechanical Systems, 2015, 24(2), pp. 333-342. La valeur du champ magnétique est alors déduite d'un décalage de la fréquence de résonance de l'oscillateur, qui est produit par la force de Lorentz. Etant donné que ce décalage de la fréquence de résonance apparaît immédiatement après l'application du champ magnétique, la durée d'une mesure est fortement réduite par rapport au cas précédent de la mesure d'une amplitude de vibration par détection synchrone. Mais le circuit électrique de mesure d'un tel magnétomètre n'est pas adapté à des interactions entre le paramètre à mesurer et le résonateur qui génèrent des déphasages de valeurs quelconques dans une force supplémentaire d'excitation qui résulte d'une valeur non nulle du paramètre à mesurer et est appliquée au résonateur.

Le document WO 2009/109897 concerne un détecteur de gaz par effet photo-acoustique, dans lequel la grandeur physique qui est mesurée est un déphasage dû à l'effet de perturbation que crée une branche de mesure sur un oscillateur. Il indique d'ajuster un alignement entre un faisceau laser qui est utilisé pour produire l'effet photo-acoustique, et un diapason qui constitue un résonateur électromécanique.

Enfin, le document US 2011/0179872 concerne un circuit électrique de détection d'amplitude, qui est destiné à être incorporé dans un capteur d'une quantité physique, tel qu'un capteur de vitesse angulaire.

A partir de cette situation, un but de la présente invention consiste à effectuer des mesures, en particulier des mesures d'une concentration d'un gaz, avec une durée de mesure individuelle qui soit courte.

Un autre but de l'invention consiste à obtenir des résultats de mesures qui soient indépendants, ou dépendent peu, de conditions externes telles que la pression et la température ambiantes.

Enfin, un but complémentaire de l'invention consiste à fournir un détecteur de gaz qui soit peu onéreux et peu encombrant.

Pour atteindre l'un au moins de ces buts ou d'autres, un premier aspect de l'invention propose un circuit électrique de mesure qui comprend :

- un résonateur électromécanique ;

- une branche électrique de réaction, ayant une entrée qui est connectée à une borne de détection du résonateur pour recueillir un signal de réponse de ce résonateur, et une sortie qui est connectée à une borne d'excitation du résonateur pour appliquer une force d'excitation au résonateur, de sorte que le résonateur et la branche électrique de réaction forment une partie au moins d'un oscillateur fonctionnant à une fréquence de résonance ;

- un dispositif de mesure de fréquence, qui est connecté à l'oscillateur de façon à mesurer la fréquence de résonance ; et

- une branche de mesure, ayant une entrée qui est connectée à la sortie de la branche électrique de réaction, et une sortie de modulation qui est adaptée pour transmettre un signal de modulation à un dispositif externe, en fonction d'un signal d'excitation qui existe à la sortie de la branche électrique de réaction.

Ainsi, lorsque le dispositif externe est adapté pour appliquer au résonateur, en plus de la force d'excitation appliquée par la branche électrique de réaction, une force d'excitation supplémentaire, alors un décalage de la fréquence de résonance qui est détecté au moyen du dispositif de mesure de fréquence, et qui résulte de la force d'excitation supplémentaire, constitue une mesure d'un paramètre du dispositif externe.

Selon l'invention, la branche de mesure comprend un déphaseur ajustable qui est agencé entre l'entrée et la sortie de modulation de cette branche de mesure, de sorte qu'un déphasage de la force d'excitation supplémentaire qui appliquée par le dispositif externe au résonateur soit réglable. Ainsi la force d'excitation supplémentaire peut être amenée en quadrature de phase par rapport à la force d'excitation qui est appliquée par la branche électrique de réaction.

Grâce à l'utilisation du déphaseur ajustable, le circuit électrique de mesure de l'invention est adapté à des interactions entre le paramètre à mesurer du dispositif externe et le résonateur qui introduisent des déphasages quelconques. En effet, le déphaseur ajustable permet d'adapter le circuit électrique de mesure individuellement à chaque dispositif externe qui produit l'interaction entre le paramètre à mesurer et le résonateur.

En outre, le circuit électrique de mesure de l'invention possède une architecture en double boucle de réaction : la branche électrique de réaction forme une première boucle avec le résonateur, et la branche de mesure forme une seconde boucle avec le dispositif externe et le résonateur. Une telle architecture assure que la fréquence du signal de modulation soit asservie à la fréquence de résonance de l'oscillateur. De cette façon, la réponse d'un détecteur qui incorpore le circuit est le décalage de la fréquence de résonance, et elle reproduit de façon instantanée ou quasi-instantanée des variations du paramètre à mesurer. Le circuit électrique de mesure de l'invention permet donc des mesures dont la durée individuelle d'acquisition est très courte. Le détecteur est alors adapté à des applications qui nécessitent des mesures rapides, telles que des applications pour lesquelles des conditions externes ou ambiantes sont susceptibles de varier, ou des applications de détection et de mesure de concentration d'un gaz toxique, ou encore des applications relatives à plusieurs gaz différents qui sont l'objet de mesures réalisées cycliquement les unes à la suite des autres.

Enfin, un circuit électrique de mesure qui est conforme à l'invention peut être réalisé à bas coût, en utilisant des composants fabriqués en grandes séries sous forme de circuits électroniques intégrés et de systèmes micro-électromécaniques, désignés par l'acronyme MEMS en anglais. En particulier, le résonateur peut être du type à élément de quartz vibrant, par exemple du type à diapason en quartz, ou du type à élément de silicium vibrant, par exemple du type diapason en silicium.

Dans des modes alternatifs de réalisation de l'invention, la branche électrique de réaction peut comprendre un amplificateur et un déphaseur qui sont associés en série, ou bien comprendre un assemblage de boucle à verrouillage de phase.

Avantageusement, la branche de mesure peut être adaptée pour appliquer réversiblement un déphasage supplémentaire qui est égal à pi, en plus du déphasage qui est réglable au moyen du déphaseur ajustable. Ainsi, le décalage de la fréquence de résonance qui constitue la mesure du paramètre du dispositif externe, peut être égal à la moitié d'une différence entre deux valeurs qui sont mesurées pour la fréquence de résonance avec et sans le déphasage supplémentaire égal à pi, respectivement. De cette façon, l'influence de conditions externes telles que la pression et la température ambiantes sur les résultats de mesure est supprimée au premier ordre.

Alternativement, pour supprimer avec plus d'exactitude l'influence de conditions externes ou ambiantes sur les résultats de mesure, le circuit électrique de mesure peut comprendre en outre :

- un résonateur électromécanique de référence ; et

- une autre branche électrique de réaction, ayant une entrée qui est connectée à une borne de détection du résonateur de référence pour recueillir un signal de réponse de ce résonateur de référence, et une sortie qui est connectée à une borne d'excitation du résonateur de référence pour appliquer une autre force d'excitation au résonateur de référence, de sorte que le résonateur de référence et la ainsi-nommée autre branche électrique de réaction forment un oscillateur de référence fonctionnant à une autre fréquence de résonance, dite fréquence de référence, indépendamment de l'oscillateur qui est connecté à la branche de mesure.

Dans ce cas, le circuit électrique de mesure est adapté en outre pour mesurer la fréquence de référence séparément de la fréquence de résonance de l'oscillateur qui est connecté à la branche de mesure. Alors le décalage de la fréquence de résonance qui constitue la mesure du paramètre du dispositif externe, correspond à une différence entre la fréquence de résonance qui est mesurée pour l'oscillateur connecté à la branche de mesure et la fréquence de référence.

Un deuxième aspect de l'invention propose un détecteur de gaz qui comprend :

- un circuit électrique de mesure, qui est conforme au premier aspect de l'invention, éventuellement avec les perfectionnements indiqués ci-dessus ; et

- un laser modulable constituant le dispositif externe, avec la sortie de modulation de la branche de mesure qui est connectée à une entrée de modulation du laser modulable, et ce laser modulable étant orienté de sorte qu'un gaz qui posséderait une raie d'absorption correspondant à une longueur d'onde du laser modulable, et qui recevrait un faisceau de rayonnement issu de ce laser modulable, produise une onde acoustique, et cette onde acoustique produise la force d'excitation supplémentaire sur le résonateur.

Pour un tel détecteur de gaz, le paramètre qui est mesuré par le décalage de la fréquence de résonance, est une concentration du gaz qui possède une raie d'absorption à une longueur d'onde du laser modulable.

Dans un tel détecteur de gaz conforme à l'invention, le laser modulable peut être modulable en longueur d'onde ou en puissance de rayonnement, pour le faisceau de rayonnement qui est issu de ce laser modulable.

Aussi dans un détecteur de gaz qui est conforme à l'invention, le résonateur peut comprendre un diapason, et le laser modulable peut être orienté de sorte que le faisceau de rayonnement qui est issu de ce laser modulable soit perpendiculaire à deux branches du diapason. Le faisceau de rayonnement peut ainsi passer entre les deux branches du diapason dans un plan de symétrie du diapason, ou bien passer sur un côté d'une des deux branches du diapason qui est opposé à l'autre branche.

Enfin, un troisième aspect de l'invention propose un procédé de mesure d'une concentration d'un gaz, qui comprend les étapes suivantes :

/1/ sélectionner un détecteur de gaz qui est conforme au deuxième aspect de l'invention, et pour lequel une longueur d'onde du laser modulable correspond à une raie d'absorption du gaz ;

/2/ disposer le détecteur de gaz de sorte que le faisceau de rayonnement qui est issu du laser modulable traverse une zone susceptible de contenir une quantité du gaz ;

/3/ régler le déphaseur ajustable de la branche de mesure, de sorte que la force d'excitation supplémentaire qui appliquée par le dispositif externe au résonateur soit en quadrature de phase par rapport à la force d'excitation qui est appliquée par la branche électrique de réaction ;

/4/ mesurer un décalage de la fréquence de résonance de l'oscillateur, qui résulte de la force d'excitation supplémentaire ; et

/5/ déduire une valeur de la concentration du gaz, à partir du décalage mesuré pour la fréquence de résonance.

La valeur de concentration du gaz peut être déduite du décalage de la fréquence de résonance, à l'étape /5/, en utilisant la formule :

$$C_{gaz} = [3 \cdot Q \cdot N_x \cdot V_x/(4 \cdot \beta \cdot f_r)] \cdot \Delta f_r$$

où Q et $f_r$ sont respectivement un facteur de qualité et une fréquence propre de vibration du résonateur électromécanique, $N_x$ est un facteur de conversion piézoélectrique de ce résonateur électromécanique, $V_x$ est une amplitude de tension d'excitation du résonateur électromécanique, et $\beta$ est un nombre constant qui est indépendant de la concentration du gaz.

Dans des mises en œuvre particulières du procédé de l'invention, l'étape /3/ peut comprendre les sous-étapes suivantes :

- mesurer une fréquence de l'oscillateur en temps réel pendant un fonctionnement du détecteur de gaz ; et

- régler le déphaseur ajustable de la branche de mesure pour que cette fréquence de l'oscillateur telle que mesurée soit maximale.

Enfin, lorsque le résonateur comprend un diapason, le déphaseur ajustable peut être réglé à l'étape /3/ pour produire un déphasage qui est égal à :

$$\frac{\pi}{2} - Arctan\left(2\pi f_r \tau_{V-T}\right) + Arctan\left(\frac{\int_{-\frac{l}{2}}^{\frac{l}{2}}\left[Y_0\left(\frac{2\pi f_r}{c}r_{in}\right) - Y_0\left(\frac{2\pi f_r}{c}r_{ext}\right)\right]dz}{\int_{-\frac{l}{2}}^{\frac{l}{2}}\left[J_0\left(\frac{2\pi f_r}{c}r_{in}\right) - J_0\left(\frac{2\pi f_r}{c}r_{ext}\right)\right]dz}\right)$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$ et où Oz est un axe parallèle à une direction longitudinale des branches du diapason avec un point d'origine qui est situé à un pied des branches, H est une première distance mesurée parallèlement à l'axe Oz entre le pied des branches du diapason et un centre du faisceau de rayonnement qui est issu du laser modulable, L est une seconde distance mesurée perpendiculairement à l'axe Oz entre le centre du faisceau de rayonnement et le diapason, e est une épaisseur des branches du diapason mesurée parallèlement à la seconde distance L, c est une vitesse de propagation du son dans le gaz, $f_r$ est encore la fréquence propre de vibration du résonateur électromécanique, $\tau_{V-T}$ est un temps de relaxation du gaz, et $J_0$ et $Y_0$ sont les fonctions de Bessel du premier ordre respectivement de la première et de la second espèce.

D'autres particularités et avantages de la présente invention apparaîtront dans la description ci-après d'exemples de réalisation non limitatifs, en référence aux dessins annexés, dans lesquels :

- la figure 1 est un diagramme général d'un détecteur de gaz qui est conforme à l'invention ;
- la figure 2 correspond à la figure 1 pour une réalisation alternative d'une partie du détecteur de gaz ;
- les figures 3a et 3b représentent deux agencements alternatifs d'un dispositif externe et d'un résonateur électromécanique parties du détecteur de gaz de la figure 1 ;
- la figure 4 est un diagramme général d'un détecteur de gaz qui est conforme à un perfectionnement de l'invention ; et
- la figure 5, déjà décrite, est un diagramme général d'un détecteur de gaz tel que connu avant la présente invention.

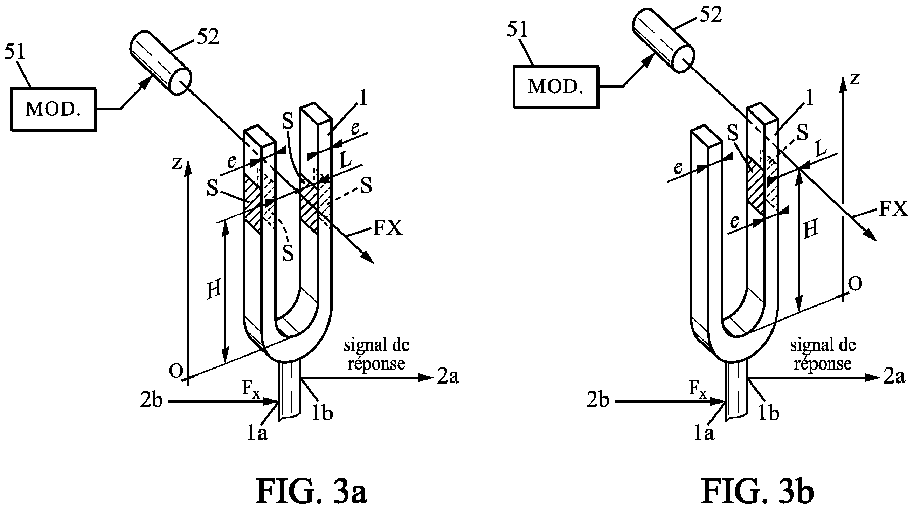

Des références identiques qui sont indiquées dans plusieurs de ces figures désignent des éléments identiques ou qui ont des fonctions identiques. En outre, pour raison de clarté, les dimensions des éléments ou parties d'éléments qui sont représentés dans les figures 3a et 3b ne correspondent ni à des dimensions réelles ni à des rapports de dimensions réels.

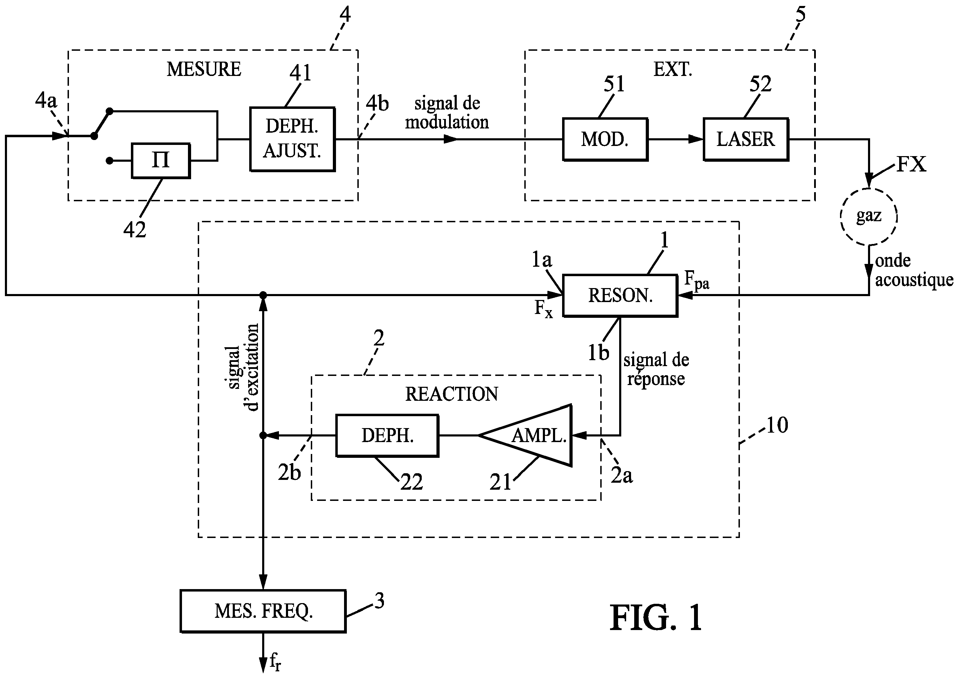

En référence à la figure 1, un oscillateur 10 comprend un résonateur électromécanique 1, noté RESON., et une branche électrique de réaction 2, notée REACTION. Pour cela, une entrée 2a de la branche de réaction 2 est connectée à une borne de détection 1b du résonateur 1, pour recevoir un signal de réponse de ce dernier, et une sortie 2b de la branche de réaction 2 est connectée à une borne d'excitation 1a du résonateur 1 pour appliquer une force

d'excitation $F_x$ au résonateur 1. Les bornes d'excitation 1a et de détection 1b du résonateur 1 sont disposées sur celui-ci d'une façon qui est connue de l'Homme du métier, et qui dépend du type et du modèle de ce résonateur. Plus précisément, la branche de réaction 2 produit à sa sortie 2b un signal d'excitation, dont résulte la force d'excitation $F_x$ lorsque le signal d'excitation est appliqué à la borne d'excitation 1a du résonateur 1.

La branche électrique de réaction 2 peut être constituée d'un amplificateur 21, noté AMPL., et d'un déphaseur 22, noté DEPH., qui sont connectés en série. Une telle réalisation de la branche de réaction 2 permet de satisfaire les deux conditions d'oscillation de Barkhausen pour une fréquence de résonance $f_r$, en fonction des caractéristiques du résonateur 1.

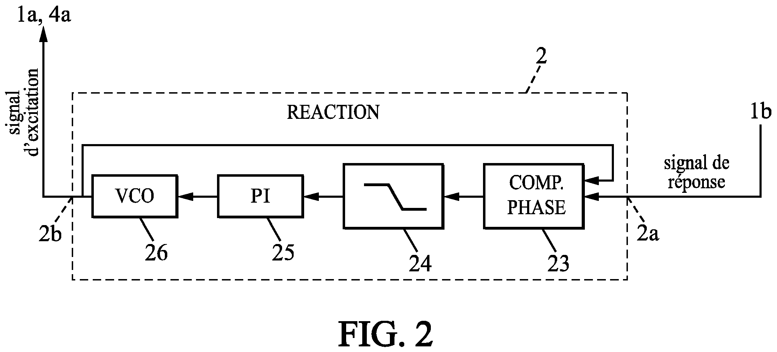

Selon une réalisation alternative qui est illustrée par la figure 2, la branche électrique de réaction 2 peut être constituée par une boucle à verrouillage de phase. Une telle boucle comprend dans l'ordre de transmission des signaux : un comparateur de phase 23, noté COMP. PHASE, un filtre passe-bas 24, un contrôleur proportionnel-intégral 25, noté PI, et un oscillateur contrôlé en tension 26, noté VCO. Le comparateur de phase 23 reçoit en entrée le signal de réponse du résonateur 1 en même temps que le signal d'oscillation de l'oscillateur contrôlé en tension 26, de sorte que la fréquence d'oscillation de l'oscillateur contrôlé en tension 26 soit identique à la fréquence de résonance $f_r$ de l'oscillateur 10.

De retour à la figure 1, la référence 3 désigne un dispositif de mesure de fréquence, qui est noté MES. FREQ. et est agencé pour mesurer en temps réel la fréquence de résonance $f_r$. Par exemple, le dispositif 3 peut être connecté à la sortie 2b de la branche de réaction 2 pour mesurer la fréquence du signal d'excitation. Plusieurs réalisations du dispositif de mesure de fréquence 3 sont bien connues de l'Homme du métier, si bien qu'il n'est pas nécessaire de les décrire à nouveau ici.

La branche de mesure 4, notée MESURE, avec le dispositif externe 5, noté EXT., forment une branche d'excitation additionnelle pour le résonateur 1, qui est effective en parallèle avec l'excitation qui est directement appliquée au résonateur 1 par la branche électrique de réaction 2. Pour cela, une entrée 4a de la branche de mesure 4 est connectée pour recevoir le signal d'excitation qui est produit par la branche de réaction 2. La branche de mesure 4 produit à sa sortie 4b un signal de modulation à partir du signal d'excitation, et ce signal de modulation est transmis au dispositif externe 5. Enfin, le dispositif externe 5 produit une force d'excitation supplémentaire $F_{pa}$, qui est appliquée au résonateur 1 en plus de la force d'excitation $F_x$. Il résulte de cette architecture du circuit électrique de mesure que la force d'excitation supplémentaire $F_{pa}$ est modulée à la fréquence du signal d'excitation qui est produit par la branche de réaction 2. Autrement dit, la fréquence du signal de modulation qui est produit par la branche de mesure 4 est asservie à la fréquence de résonance de l'oscillateur 10 complété par la branche de mesure 4 et le dispositif externe 5. Comme expliqué plus loin dans cette description, la force d'excitation supplémentaire $F_{pa}$, qui agit sur le résonateur 1 en plus de la force d'excitation $F_x$, provoque un décalage de la fréquence de résonance $f_r$ telle que mesurée par le dispositif 3. Ce décalage de la fréquence de résonance $f_r$ est alors caractéristique d'un paramètre du dispositif externe 5, et constitue une mesure quantitative de ce paramètre.

Pour une utilisation d'un tel circuit électrique de mesure dans un détecteur de gaz, le dispositif externe 5 peut être une cellule de détection de gaz à effet photo-acoustique. Le fonctionnement d'une telle cellule de détection, connu avant l'invention, a été rappelé au début de la présente description. Un tel dispositif externe comprend un modulateur 51 et une unité laser 52, qui sont agencés pour constituer ensemble un laser modulable. Celui-ci produit le faisceau de rayonnement électromagnétique FX qui est indiqué sur les figures 3a et 3b, et qui peut être modulé en puissance du rayonnement ou en longueur d'onde du rayonnement. Lorsque la modulation porte sur la longueur d'onde, le signal de modulation est obtenu à partir du signal d'excitation qui est produit par la branche de réaction 2 en divisant par deux la fréquence de ce signal d'excitation. Le faisceau FX est alors dirigé pour passer à proximité du résonateur 1, et une onde acoustique est générée lorsqu'un gaz est présent sur le trajet du faisceau FX, et que ce gaz est absorbant pour la longueur d'onde du rayonnement du faisceau FX. L'onde acoustique produit ensuite la force d'excitation supplémentaire $F_{pa}$ sur le résonateur 1, après s'être propagée à partir du lieu de l'absorption du rayonnement électromagnétique par le gaz jusqu'à au moins une surface du résonateur 1 qui est sensible à la surpression acoustique. Dans les réalisations des figures 3a et 3b, le résonateur 1 est un diapason en quartz. Conformément à la figure 3a, le faisceau laser FX peut être dirigé entre les deux branches du diapason, dans le plan de symétrie du diapason, de sorte qu'il passe simultanément à une distance L de chacune des deux branches. L'onde acoustique exerce ainsi la force $F_{pa}$ sur les deux branches du diapason, simultanément et symétriquement, avec une efficacité d'interaction qui est supérieure. Dans le cas de la figure 3b, le faisceau laser FX passe à l'extérieur du diapason, à la distance L d'une des deux branches. L'onde acoustique n'interagit alors avec le diapason essentiellement que par cette branche. Dans les deux cas, L est la distance de propagation de l'onde acoustique pour atteindre le résonateur 1. Cette distance de propagation génère un retard de phase de la force d'excitation additionnelle $F_{pa}$ par rapport au signal de modulation.

De retour à la figure 1, la branche de mesure 4 comprend un déphaseur ajustable 41, noté DEPH. AJUST., et, optionnellement un déphaseur supplémentaire 42 qui est noté $\pi$ et connecté pour être alternativement activé ou inhibé. Lorsque le déphaseur supplémentaire 42 est inhibé, seul le déphaseur ajustable 41 est effectif pour le signal de modulation par rapport au signal d'excitation. Lorsque le déphaseur supplémentaire 42 est activé, le déphasage du signal de modulation par rapport au signal d'excitation résulte de la somme des contributions respectives de déphasage du déphaseur ajustable 41 et du déphaseur supplémentaire 42. La contribution du déphaseur supplémentaire 42 est alors égale à pi ($\pi$).

D'après l'ouvrage de T.L. Cottrel et J. McCoubrey intitulé «Molecular Energy Transfer in Gases», Butterworths, London (1961), p.64, le déphasage propre à l'effet photo-acoustique est $\Phi_{pa}$ = Arctan($2\pi \cdot f_r \cdot \tau_{V-T}$). Dans cette formule, $f_r$ désigne la fréquence de modulation du laser modulable, qui est égale à la fréquence de résonance de l'oscillateur 10 complété par la branche de mesure 4 et le dispositif externe 5, $\tau_{V-T}$ est le temps de relaxation du gaz par vibration et translation des molécules ou atomes de ce gaz, et Arctan désigne l'inverse de la fonction tangente.

Par ailleurs, un déphasage additionnel résulte de la propagation de l'onde acoustique entre le lieu de l'absorption du rayonnement électromagnétique du faisceau FX par le gaz, et le résonateur 1. Pour les deux modes de réalisation des figures 3a et 3b, ce déphasage additionnel résulte de la propagation de l'onde acoustique entre le faisceau de rayonnement FX et les surfaces sensibles S du diapason. Il est alors :

$$\Phi_{ac} = Arctan\left(\frac{\int_{-\frac{l}{2}}^{\frac{l}{2}}\left[Y_0\left(\frac{2\pi f r}{c}r_{in}\right)-Y_0\left(\frac{2\pi f r}{c}r_{ext}\right)\right]dz}{\int_{-\frac{l}{2}}^{\frac{l}{2}}\left[J_0\left(\frac{2\pi f r}{c}r_{in}\right)-J_0\left(\frac{2\pi f r}{c}r_{ext}\right)\right]dz}\right)$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$ où Oz est un axe parallèle à la direction longitudinale des branches du diapason avec un point d'origine qui est situé au pied des branches, H est la distance mesurée parallèlement à l'axe Oz entre le pied des branches du diapason et un centre du faisceau de rayonnement FX, L est la distance mesurée perpendiculairement à l'axe Oz entre le centre du faisceau de rayonnement FX et chacune des surfaces sensibles S du diapason qui sont les plus proches du faisceau de rayonnement FX, e est l'épaisseur des branches du diapason mesurée parallèlement à la distance L, c est la vitesse de propagation du son dans le gaz, $f_r$ est encore la fréquence propre de vibration du résonateur électromécanique, $\tau_{V-T}$ est encore le temps de relaxation du gaz, et $J_0$ et $Y_0$ sont les fonctions de Bessel du premier ordre respectivement de la première et de la second espèce.

Le déphasage entre les deux forces d'excitation $F_x$ et $F_{pa}$ qui sont appliquées simultanément au résonateur 1 est donc :

$$\Phi_{total} = \varphi_{el} + \Phi_{pa} + \Phi_{ac}$$

où $\varphi_{el}$ est le retard de phase qui est appliqué par la branche de mesure 4 au signal d'excitation pour produire le signal de modulation.

Les deux forces d'excitation $F_x$ et $F_{pa}$ sont donc en quadrature de phase, c'est-à-dire $\Phi_{total}$ = $\pm\pi/2$, lorsque $\varphi_{el}$ + $\Phi_{pa}$ + $\Phi_{ac}$ = $\pm\pi/2$. En particulier, pour le mode de réalisation à diapason de la figure 3a, $F_x$ et $F_{pa}$ sont en quadrature de phase lorsque

$$\varphi_{el} = \frac{\pi}{2} - Arctan\left(2\pi f_r \tau_{V-T}\right) - Arctan\left(\frac{\int_{-\frac{l}{2}}^{\frac{l}{2}}\left[Y_0\left(\frac{2\pi f r}{c}r_{in}\right)-Y_0\left(\frac{2\pi f r}{c}r_{ext}\right)\right]dz}{\int_{-\frac{l}{2}}^{\frac{l}{2}}\left[J_0\left(\frac{2\pi f r}{c}r_{in}\right)-J_0\left(\frac{2\pi f r}{c}r_{ext}\right)\right]dz}\right)$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$

Alors, lorsque les deux forces d'excitation $F_x$ et $F_{pa}$ sont en quadrature de phase, le déphasage de la somme des deux forces $F_x$ et $F_{pa}$ par rapport à la force $F_x$ est $\theta$ = Arctan($F_{pa}/F_x$). Or en général, la force d'excitation supplémentaire $F_{pa}$ est beaucoup moins importante que la force d'excitation $F_x$, de sorte que $\theta$ = $F_{pa}/F_x$.

Encore du fait que la force d'excitation supplémentaire $F_{pa}$ soit beaucoup moins importante que la force d'ex-

citation $F_x$, le décalage $\Delta f_r$ de la fréquence de résonance $f_r$ qui est provoqué par la force d'excitation supplémentaire $F_{pa}$ est faible, et est égal à $\theta \cdot f_r/(2 \cdot Q)$ d'après la théorie de perturbation d'un oscillateur. Il vient alors $\Delta f_r = [f_r/(2 \cdot Q)] \cdot F_{pa}/F_x$. Au premier ordre, $f_r$ est la fréquence de résonance de l'oscillateur 10 en l'absence de gaz, ou encore la fréquence propre de vibration du résonateur 1.

Or à la fréquence de résonance, $F_x = K \cdot |x|/Q$, où $|x|$ désigne l'amplitude de vibration du résonateur 1, et K est la raideur du résonateur 1. Il vient alors $\Delta f_r = [f_r/(2 \cdot K \cdot |x|)] \cdot F_{pa}$. En supposant que l'onde acoustique produit la force d'excitation supplémentaire $F_{pa}$ au niveau de l'une ou des deux extrémités des branches d'un diapason qui constitue le résonateur 1, la formule précédente du décalage de la fréquence de résonance devient : $\Delta f_r = [4 \cdot f_r/(3 \cdot K \cdot |x|)] \cdot F_{pa}$.

A la fréquence de résonance, l'amplitude en tension $V_x$ du signal d'excitation est égale à $K \cdot |x|/(N_x \cdot Q) = F_x/N_x$, où $N_x$ est un facteur de conversion piézoélectrique du résonateur 1. Alors : $\Delta f_r = [4 \cdot f_r/(3 \cdot N_x \cdot Q \cdot V_x)] \cdot F_{pa}$.

Or, la force d'excitation supplémentaire $F_{pa}$ qui est exercée par l'onde acoustique sur le résonateur 1 est proportionnelle à la concentration du gaz à détecter: $F_{pa} = \beta \cdot C_{gaz}$, où $C_{gaz}$ est la concentration du gaz et $\beta$ est un nombre qui est indépendant de la concentration du gaz, mais qui dépend notamment de la surface effective d'action de l'onde acoustique sur le résonateur 1 et de la puissance du faisceau FX. Il vient alors : $C_{gaz} = [3 \cdot Q \cdot N_x \cdot V_x/(4 \cdot \beta \cdot f_r)] \cdot \Delta f_r$.

Pour un diapason en quartz de longueur 3,8 mm mesurée selon l'axe Oz, d'épaisseur e des branches égale à 0,600 mm, de largeur des branches égale à 0,340 mm mesurée perpendiculairement à l'épaisseur e et à l'axe Oz, et d'espace entre les branches de 0,310 mm, le facteur de qualité Q peut être égal à 15400, la fréquence propre de vibration $f_r$ peut être égale à 32762 Hz (hertz), et le coefficient de conversion piézoélectrique $N_x$ peut être égal à $9 \cdot 10^{-6}$ C/m (coulomb par mètre). Le laser modulable peut avoir une puissance moyenne égale à 17m W, et être modulé en amplitude de manière purement sinusoïdale à la fréquence $f_r$. Sa longueur d'onde est alors fixe et peut correspondre à la valeur de nombre d'onde 6490,05 cm$^{-1}$. Lorsque le gaz à détecter est du dioxyde de carbone ($CO_2$) à pression atmosphérique, associé à de la vapeur d'eau à teneur de 15%, la vitesse de propagation du son est de 260 m.s$^{-1}$ et le nombre d'onde du pic d'absorption du dioxyde de carbone est 6490,05 cm$^{-1}$. L'amplitude en tension $V_x$ du signal d'excitation peut être égale à 10 mV (millivolt), le temps de relaxation $\tau_{V-T}$ peut être égal à 0,1 $\mu$s et le nombre $\beta$ peut être égal à $8,1.10^{-13}$ N.mol$^{-1}$.m$^3$ pour la mise en œuvre du diapason qui correspond à la figure 3a.

Lorsque le déphaseur supplémentaire 42 est inhibé, le déphaseur ajustable 41 est réglé pour produire le déphasage :

$$\frac{\pi}{2} - Arctan\left(2\pi f_r \tau_{V-T}\right) + Arctan\left(\frac{\int_{-\frac{l}{2}}^{\frac{l}{2}}\left[Y_0\left(\frac{2\pi f_r}{c}r_{in}\right) - Y_0\left(\frac{2\pi f_r}{c}r_{ext}\right)\right]dz}{\int_{-\frac{l}{2}}^{\frac{l}{2}}\left[J_0\left(\frac{2\pi f_r}{c}r_{in}\right) - J_0\left(\frac{2\pi f_r}{c}r_{ext}\right)\right]dz}\right)$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$

Ce réglage peut être effectué en calculant numériquement la valeur du déphasage, c'est-à-dire en reportant dans sa formule des valeurs connues pour la fréquence propre de vibration $f_r$ du résonateur 1, le temps de relaxation $\tau_{V-T}$, la distance L et la longueur d'onde acoustique À, cette dernière étant égale à la vitesse de propagation du son divisée par la fréquence $f_r$. La valeur de déphasage qui est ainsi calculée est ensuite appliquée au déphaseur ajustable 41. Par exemple, la fréquence propre de vibration $f_r$ du diapason peut être encore égale à 32762 Hz, le temps de relaxation $\tau_{V-T}$ peut être égal à 0,1 $\mu$s (microseconde), la longueur d'onde acoustique peut être égale à 0,8 cm (centimètre), et la distance L entre les branches du diapason peut être égale à 0,155 mm (millimètre). Pour ces valeurs numériques, on obtient une valeur de déphasage égale à 0,67 radian à appliquer au déphaseur ajustable 41.

Alternativement, la fréquence de l'oscillateur peut être mesurée, par exemple au moyen d'un compteur-fréquencemètre. Le déphaseur ajustable 41 peut alors être réglé empiriquement pour que la fréquence de l'oscillateur soit maximale.

A partir de ce réglage du déphaseur ajustable 41, et lorsque le déphaseur supplémentaire 42 est activé, le déphasage qui est introduit par la branche de mesure 4 devient

$$\varphi_{el} = \frac{\pi}{2} - Arctan\left(2\pi f_r \tau_{V-T}\right) - Arctan\left(\frac{\int_{-\frac{l}{2}}^{\frac{l}{2}}\left[Y_0\left(\frac{2\pi f_r}{c}r_{in}\right) - Y_0\left(\frac{2\pi f_r}{c}r_{ext}\right)\right]dz}{\int_{-\frac{l}{2}}^{\frac{l}{2}}\left[J_0\left(\frac{2\pi f_r}{c}r_{in}\right) - J_0\left(\frac{2\pi f_r}{c}r_{ext}\right)\right]dz}\right) + \pi$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$

Il est à noter que la force d'excitation supplémentaire $F_{pa}$ est encore en quadrature de phase avec la force d'excitation $F_x$. Le déphasage de pi radians qui est ajouté par le déphaseur supplémentaire 42 a pour effet d'inverser le signe de la force d'excitation supplémentaire $F_{pa}$, et donc d'inverser aussi le signe du déphasage $\theta$ de la somme des deux forces d'excitation $F_x$ et $F_{pa}$ par rapport à la force d'excitation $F_x$. Autrement dit, le déphasage effectif qui intervient dans l'oscillateur 10 complété par la branche de mesure 4 et le dispositif externe 5, est opposé à celui qui existe lorsque le déphaseur supplémentaire 42 est inhibé. Alors, pour une même concentration du gaz, l'activation du déphaseur supplémentaire 42 change le décalage $\Delta f_r$ en son opposé $-\Delta f_r$. Par conséquent, calculer une demi-différence des deux fréquences de résonance $f_r$ qui sont mesurées par le dispositif 3 respectivement en inhibant et en activant le déphaseur supplémentaire 42, fournit la valeur numérique du décalage $\Delta f_r$. Cette méthode permet de s'affranchir de contributions additives parasites qui sont dues à des variations de conditions externes telles que des variations de pression et de température ambiantes, dans le décalage apparent $\Delta f_r$ qui serait calculé par rapport à une valeur fixe adoptée pour la fréquence de résonance $f_r$.

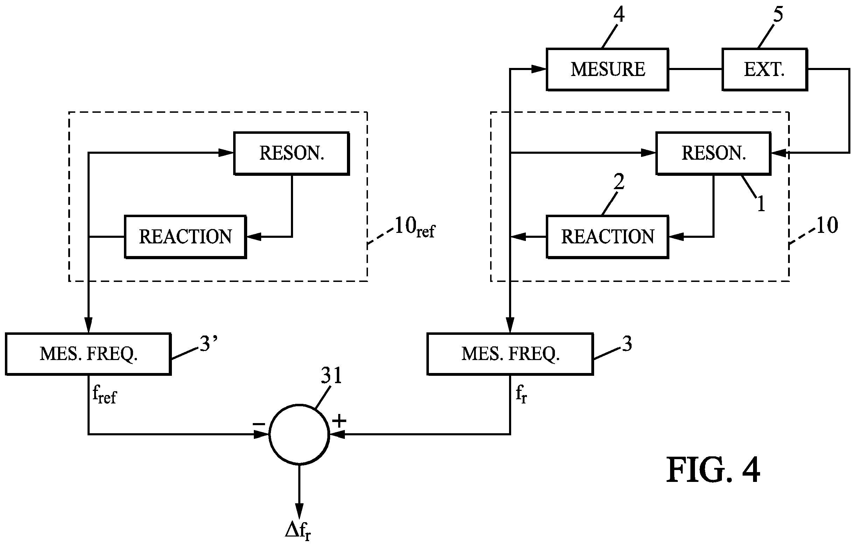

La figure 4 illustre une autre façon de s'affranchir des variations de conditions externes telles que la pression et la température ambiantes, pour le résultat de concentration gazeuse qui est obtenu. La partie droite de la figure 4 reprend identiquement l'ensemble de la figure 1, sans le déphaseur supplémentaire 42. L'oscillateur 10 est dupliqué à l'identique, pour former un oscillateur de référence $10_{ref}$. Cet oscillateur de référence $10_{ref}$ est associé à un dispositif de mesure de fréquence 3', qui peut être identique au dispositif 3. Le dispositif 3 fournit ainsi une mesure de la fréquence de résonance $f_r$ telle que modifiée par la présence du gaz, alors que le dispositif 3' fournit une mesure de la fréquence de résonance sans effet de la présence du gaz. Cette dernière est notée $f_{ref}$ et a été appelée fréquence de référence dans la partie générale de cette description. Alors, l'écart $\Delta f_r = f_r - f_{ref}$ qui est mesuré ou calculé par le soustracteur 31 peut être introduit dans la formule $C_{gaz} = [3 \cdot Q \cdot N_x \cdot V_x/(4 \cdot \beta \cdot f_r)] \cdot \Delta f_r$, et fournit une valeur pour la concentration du gaz qui est affranchie d'erreurs dues à des variations de conditions externes.

Il est entendu que l'invention peut être reproduite en modifiant ou adaptant des aspects secondaires de celle-ci par rapport à la description détaillée qui vient d'être fournie. Toutefois, il est rappelé que par rapport aux détecteurs de gaz qui étaient connus avant la présente invention et qui utilisent aussi l'effet photo-acoustique, un détecteur de gaz conforme à l'invention possède en plus la branche électrique de réaction 2 qui aboutit au résonateur 1, pour lui appliquer la force d'excitation $F_x$. Il possède aussi en plus la branche de mesure 4 qui est alimentée en entrée par le signal d'excitation produit par la branche électrique de réaction 2. Pour une telle architecture de détecteur de gaz, l'invention introduit alors le déphaseur ajustable 41 dans la branche de mesure, afin d'ajuster la force d'excitation supplémentaire $F_{pa}$ en quadrature de phase par rapport à force d'excitation $F_x$.

**Revendications**

1. Détecteur de gaz, comprenant :

   - un circuit électrique de mesure, ledit circuit électrique de mesure comprenant :

      - un résonateur électromécanique (1) ;
      - une branche électrique de réaction (2), ayant une entrée (2a) connectée à une borne de détection (1b) du résonateur (1) pour recueillir un signal de réponse dudit résonateur, et une sortie (2b) connectée à une borne d'excitation (1a) du résonateur pour appliquer une force d'excitation ($F_x$) audit résonateur, de sorte que le résonateur et la branche électrique de réaction forment une partie au moins d'un oscillateur (10) fonctionnant à une fréquence de résonance ($f_r$);
      - un dispositif de mesure de fréquence (3), connecté à l'oscillateur (10) de façon à mesurer la fréquence de résonance ($f_r$); et

- une branche de mesure (4), ayant une entrée (4a) connectée à la sortie (2b) de la branche électrique de réaction (2), et une sortie de modulation (4b) adaptée pour transmettre un signal de modulation à un dispositif externe (5), en fonction d'un signal d'excitation qui existe à la sortie (2b) de la branche électrique de réaction (2),

de sorte que lorsque le dispositif externe (5) est adapté pour appliquer au résonateur (1), en plus de la force d'excitation ($F_x$) appliquée par la branche électrique de réaction (2), une force d'excitation supplémentaire ($F_{pa}$), alors un décalage de la fréquence de résonance ($f_r$) qui est mesuré par le dispositif de mesure de fréquence (3), et qui résulte de la force d'excitation supplémentaire, constitue une mesure d'un paramètre du dispositif externe (5), le détecteur de gaz comprenant en outre :

- un laser modulable constituant le dispositif externe (5) avec la sortie de modulation (4b) de la branche de mesure (4) qui est connectée à une entrée de modulation du laser modulable, et ledit laser modulable étant orienté de sorte qu'un gaz qui posséderait une raie d'absorption correspondant à une longueur d'onde du laser modulable, et qui recevrait un faisceau de rayonnement (FX) issu dudit laser modulable, produise une onde acoustique, et ladite onde acoustique produise la force d'excitation supplémentaire ($F_{pa}$) sur le résonateur (1),

de sorte que le paramètre qui est mesuré par le décalage de la fréquence de résonance ($f_r$), soit une concentration du gaz qui possède une raie d'absorption à une longueur d'onde du laser modulable, le détecteur de gaz étant **caractérisé en ce que** la branche de mesure (4) du circuit électrique de mesure comprend un déphaseur ajustable (41) qui est agencé entre l'entrée (4a) et la sortie de modulation (4b) de ladite branche de mesure, de sorte qu'un déphasage de la force d'excitation supplémentaire ($F_{pa}$) qui appliquée par le dispositif externe (5) au résonateur (1) soit réglable, afin que ladite force d'excitation supplémentaire soit en quadrature de phase par rapport à la force d'excitation ($F_x$) qui est appliquée par la branche électrique de réaction (2).

2. Détecteur de gaz selon la revendication 1, dans lequel le résonateur (1) du circuit électrique de mesure est du type à élément de quartz vibrant, par exemple du type à diapason en quartz, ou du type à élément de silicium vibrant, par exemple du type à diapason en silicium.

3. Détecteur de gaz selon la revendication 1 ou 2, dans lequel la branche électrique de réaction (2) du circuit électrique de mesure comprend un amplificateur (21) et un déphaseur (22) qui sont associés en série, ou comprend un assemblage de boucle à verrouillage de phase.

4. Détecteur de gaz selon l'une quelconque des revendications 1 à 3, dans lequel la branche de mesure (4) du circuit électrique de mesure est adaptée pour appliquer réversiblement un déphasage supplémentaire qui est égal à pi, en plus du déphasage qui est réglable au moyen du déphaseur ajustable (41), de sorte que le décalage de la fréquence de résonance ($f_r$) qui constitue la mesure du paramètre du dispositif externe (5), soit égal à la moitié d'une différence entre deux valeurs qui sont mesurées pour la fréquence de résonance ($f_r$) avec et sans le déphasage supplémentaire égal à pi, respectivement.

5. Détecteur de gaz selon l'une quelconque des revendications 1 à 3, dans lequel le circuit électrique de mesure comprend en outre :

- un résonateur électromécanique de référence ; et
- une autre branche électrique de réaction, ayant une entrée connectée à une borne de détection du résonateur de référence pour recueillir un signal de réponse dudit résonateur de référence, et une sortie connectée à une borne d'excitation du résonateur de référence pour appliquer une autre force d'excitation audit résonateur de référence, de sorte que le résonateur de référence et ladite autre branche électrique de réaction forment un oscillateur de référence ($10_{ref}$) fonctionnant à une autre fréquence de résonance, dite fréquence de référence ($f_{ref}$), indépendamment de l'oscillateur (10) qui est connecté à la branche de mesure (4) ;

et le circuit électrique de mesure est adapté en outre pour mesurer la fréquence de référence ($f_{ref}$) séparément de la fréquence de résonance ($f_r$) de l'oscillateur (10) qui est connecté à la branche de mesure (4), de sorte que le décalage de la fréquence de résonance ($f_r$) qui constitue la mesure du paramètre du dispositif externe (5), corresponde à une différence entre la fréquence de résonance ($f_r$) mesurée pour l'oscillateur qui est connecté à la branche de mesure et la fréquence de référence.

6. Détecteur de gaz selon l'une quelconque des revendications précédentes, dans lequel le laser modulable est modulable en longueur d'onde ou en puissance de rayonnement, pour le faisceau de rayonnement (FX) qui est issu dudit laser modulable.

7. Détecteur de gaz selon l'une quelconque des revendications précédentes, dans lequel le résonateur (1) comprend un diapason, et le laser modulable est orienté de sorte que le faisceau de rayonnement (FX) qui est issu dudit laser modulable soit perpendiculaire à deux branches du diapason, et passe entre les deux branches du diapason dans un plan de symétrie dudit diapason, ou passe sur un côté d'une des deux branches du diapason qui est opposé à l'autre branche dudit diapason.

8. Procédé de mesure d'une concentration d'un gaz, comprenant les étapes suivantes :

   /1/ sélectionner un détecteur de gaz qui est conforme à l'une quelconque des revendications précédentes, et pour lequel une longueur d'onde du laser modulable correspond à une raie d'absorption du gaz ;
   /2/ disposer le détecteur de gaz de sorte que le faisceau de rayonnement (FX) qui est issu du laser modulable traverse une zone susceptible de contenir une quantité du gaz ;
   /3/ régler le déphaseur ajustable (41) de la branche de mesure (4), de sorte que la force d'excitation supplémentaire ($F_{pa}$) qui appliquée par le dispositif externe (5) au résonateur (1) soit en quadrature de phase par rapport à la force d'excitation ($F_x$) qui est appliquée par la branche électrique de réaction (2) ;
   /4/ mesurer un décalage de la fréquence de résonance ($f_r$) de l'oscillateur (10), qui résulte de la force d'excitation supplémentaire ($F_{pa}$) ; et
   /5/ déduire une valeur de la concentration du gaz, à partir du décalage mesuré pour la fréquence de résonance ($f_r$).

9. Procédé selon la revendication 8, suivant lequel la valeur de la concentration du gaz est déduite du décalage de la fréquence de résonance ($f_r$), à l'étape /5/ en utilisant la formule :

$$C_{gaz} = [3 \cdot Q \cdot N_x \cdot V_x / (4 \cdot \beta \cdot f_r)] \cdot \Delta f_r$$

où $Q$ et $f_r$ sont respectivement un facteur de qualité et une fréquence propre de vibration du résonateur électromécanique (1), $N_x$ est un facteur de conversion piézoélectrique dudit résonateur électromécanique, $V_x$ est une amplitude de tension d'excitation dudit résonateur électromécanique, et $\beta$ est un nombre constant qui est indépendant de la concentration du gaz.

10. Procédé selon la revendication 8 ou 9, suivant lequel l'étape /3/ comprend les sous-étapes suivantes :

   - mesurer une fréquence de l'oscillateur (10) en temps réel pendant un fonctionnement du détecteur de gaz ; et
   - régler le déphaseur ajustable (41) de la branche de mesure (4) pour que ladite fréquence de l'oscillateur telle que mesurée soit maximale.

11. Procédé selon l'une quelconque des revendications 8 à 10, suivant lequel le résonateur (1) comprend un diapason, et suivant lequel le déphaseur ajustable (41) est réglé à l'étape /3/ pour produire un déphasage égal à :

$$\frac{\pi}{2} - Arctan\left(2\pi f_r \tau_{V-T}\right) - Arctan\left(\frac{\int_{-\frac{l}{2}}^{\frac{l}{2}}\left[Y_0\left(\frac{2\pi f_r}{c}r_{in}\right) - Y_0\left(\frac{2\pi f_r}{c}r_{ext}\right)\right]dz}{\int_{-\frac{l}{2}}^{\frac{l}{2}}\left[J_0\left(\frac{2\pi f_r}{c}r_{in}\right) - J_0\left(\frac{2\pi f_r}{c}r_{ext}\right)\right]dz}\right)$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$ où Oz est un axe parallèle à une direction longitudinale de branches du diapason avec un point d'origine qui est situé à un pied des branches, H est une première distance mesurée parallèlement à l'axe Oz entre le pied des branches du diapason et un centre du faisceau de rayonnement (FX) qui est issu du laser modulable, L est une seconde distance mesurée perpendiculairement à l'axe Oz entre ledit centre du faisceau de rayonnement et le diapason, e est une épaisseur des branches du diapason mesurée parallèlement à la seconde distance L, c est une vitesse de propagation du son dans le gaz, $f_r$ est la fréquence propre de vibration du résonateur électromécanique, $\tau_{V\text{-}T}$ est un temps de relaxation du gaz, et $J_0$ et $Y_0$ sont les fonctions de Bessel du premier ordre respectivement de la première et de la second espèce.

**Patentansprüche**

1. Gasdetektor, umfassend:

    - eine elektrische Messschaltung, wobei die elektrische Messschaltung umfasst:

        - einen elektromechanischen Resonator (1);
        - einen elektrischen Rückkopplungsabschnitt (2), der einen Eingang (2a) aufweist, welcher mit einem Detektionsanschluss (1b) des Resonators (1) verbunden ist, um ein Antwortsignal von dem Resonator aufzunehmen, und einen Ausgang (2b), der mit einem Erregungsanschluss (1a) des Resonators verbunden ist, um eine Erregungskraft ($F_x$) auf den Resonator auszuüben, derart, dass der Resonator und der elektrische Rückkopplungsabschnitt wenigstens einen Teil eines Oszillators (10) bilden, der mit einer Resonanzfrequenz ($f_r$) arbeitet;
        - eine Frequenzmessvorrichtung (3), die mit dem Oszillator (10) dazu verbunden ist, die Resonanzfrequenz ($f_r$) zu messen; und
        - einen Messabschnitt (4) mit einem Eingang (4a), der mit dem Ausgang (2b) des elektrischen Rückkopplungsabschnitts (2) verbunden ist, und einem Modulationsausgang (4b), der dazu ausgelegt ist, in Abhängigkeit von einem am Ausgang (2b) des elektrischen Rückkopplungsabschnitts (2) vorhandenen Erregungssignal ein Modulationssignal an eine externe Vorrichtung (5) zu übertragen,

    derart dass, wenn die externe Vorrichtung (5) dazu ausgebildet ist, auf den Resonator (1) zusätzlich zu der Anregungskraft ($F_x$), die durch den elektrischen Rückkopplungsabschnitt (2) ausgeübt wird, eine zusätzliche Anregungskraft ($F_{pa}$) auszuüben, eine Verschiebung der Resonanzfrequenz ($f_r$), der durch die Frequenzmessvorrichtung (3) gemessen wird und der sich aus der zusätzlichen Anregungskraft ergibt, ein Maß für einen Parameter der externen Vorrichtung (5) darstellt,
    wobei der Gasdetektor ferner umfasst:

    - einen modulierbaren Laser, der die externe Vorrichtung (5) bildet, mit dem Modulationsausgang (4b) des Messabschnittes (4), der mit einem Modulationseingang des modulierbaren Lasers verbunden ist, und wobei der modulierbare Laser derart ausgerichtet ist, dass ein Gas, welches eine Absorptionslinie entsprechend einer Wellenlänge des modulierbaren Lasers aufweisen würde und welches einen Strahlungsstrahl (FX) von dem modulierbaren Laser empfangen würde, eine akustische Welle erzeugt, und die akustische Welle die zusätzliche Anregungskraft ($F_{pa}$) auf den Resonator (1) erzeugt,

    derart, dass der durch die Resonanzfrequenzverschiebung ($f_r$) gemessene Parameter eine Konzentration des Gases ist, das eine Absorptionslinie bei einer Wellenlänge des modulierten Lasers aufweist,
    wobei der Gasdetektor **dadurch gekennzeichnet ist, dass** der Messabschnitt (4) der elektrischen Messschaltung einen einstellbaren Phasenschieber (41) umfasst, der zwischen dem Eingang (4a) und dem Modulationsausgang (4b) des genannten Messabschnitts angeordnet ist, derart dass eine Phasenverschiebung der zusätzlichen Anregungskraft ($F_{pa}$), die von der externen Vorrichtung (5) auf den Resonator (1) ausgeübt wird, einstellbar ist, so dass diese zusätzliche Anregungskraft in Phasenquadratur in Bezug auf die Anregungskraft ($F_x$) ist, die von dem elektrischen Rückkopplungsabschnitt (2) ausgeübt wird.

2. Gasdetektor nach Anspruch 1, wobei der Resonator (1) der elektrischen Messschaltung vom Typ schwingendes Quarzelement ist, z.B. vom Typ Quarz-Stimmgabel, oder vom Typ schwingendes Siliziumelement, z.B. vom Typ Silizium-Stimmgabel.

3. Gasdetektor nach Anspruch 1 oder 2, wobei der elektrische Rückkopplungsabschnitt (2) der elektrischen Messschaltung einen Verstärker (21) und einen Phasenschieber (22) umfasst, die in Reihe zugeordnet sind, oder eine Phasenverriegelungsschleifenanordnung umfasst.

4. Gasdetektor nach einem der Ansprüche 1 bis 3, wobei der Messabschnitt (4) der Messschaltung dazu ausgebildet ist, zusätzlich zu der mittels des einstellbaren Phasenschiebers (41) einstellbaren Phasenverschiebung reversibel eine zusätzliche Phasenverschiebung gleich pi anzuwenden,
derart dass die Verschiebung der Resonanzfrequenz ($f_r$), die das Maß für den Parameter der externen Vorrichtung (5) ist, gleich der Hälfte einer Differenz zwischen zwei für die Resonanzfrequenz ($f_r$) gemessenen Werten mit bzw. ohne die zusätzliche Phasenverschiebung gleich pi ist.

**5.** Gasdetektor nach einem der Ansprüche 1 bis 3, wobei die elektrische Messschaltung ferner umfasst:

- einen elektromechanischen Referenzresonator; und
- einen weiteren elektrischen Rückkopplungsabschnitt mit einem Eingang, welcher mit einem Detektionsanschluss des Referenzresonators verbunden ist, um ein Antwortsignal von dem Referenzresonator aufzunehmen, und mit einem Ausgang, der mit einem Anregungsanschluss des Referenzresonators verbunden ist, um eine weitere Anregungskraft auf den Referenzresonator auszuüben, so dass der Referenzresonator und der andere elektrische Rückkopplungsabschnitt einen Referenzoszillator ($10_{ref}$) bilden, welcher auf einer anderen Resonanzfrequenz, Referenzfrequenz ($f_{ref}$) genannt, arbeitet, unabhängig von dem Oszillator (10), der mit dem Messabschnitt (4) verbunden ist;

und wobei die Messschaltung ferner dazu ausgebildet ist, die Referenzfrequenz ($f_{ref}$) getrennt von der Resonanzfrequenz (fr) des mit dem Messabschnitt (4) verbundenen Oszillators (10) zu messen, derart dass die Verschiebung der Resonanzfrequenz ($f_r$), der die Messung des Parameters der externen Vorrichtung (5) darstellt, einer Differenz zwischen der für den mit dem Messabschnitt verbundenen Oszillator gemessenen Resonanzfrequenz ($f_r$) und der Referenzfrequenz entspricht.

**6.** Gasdetektor nach einem der vorhergehenden Ansprüche, wobei der modulierbare Laser in der Wellenlänge oder der Strahlungsleistung modulierbar ist, für den Strahlungsstrahl (FX), der von dem modulierbaren Laser ausgegeben wird.

**7.** Gasdetektor nach einem der vorhergehenden Ansprüche, wobei der Resonator (1) eine Stimmgabel umfasst und der modulierbare Laser derart ausgerichtet ist, dass der Strahlungsstrahl (FX), der von dem modulierbaren Laser ausgegeben wird, senkrecht zu zwei Schenkeln der Stimmgabel verläuft und zwischen den beiden Schenkeln der Stimmgabel in einer Symmetrieebene der Stimmgabel verläuft, oder auf einer Seite eines der beiden Schenkel der Stimmgabel verläuft, die der anderen Seite der Stimmgabel gegenüberliegt.

**8.** Verfahren zum Messen einer Gaskonzentration, welches die folgenden Schritte umfasst:

/1/ Auswählen eines Gasdetektors nach einem der vorhergehenden Ansprüche, und wobei eine Wellenlänge des modulierbaren Lasers einer Absorptionslinie des Gases entspricht;
/2/ Anordnen des Gasdetektors derart, dass der Strahlungsstrahl (FX), der von dem modulierbaren Laser stammt, durch einen Bereich verläuft, der eine Menge des Gases enthalten kann;
/3/ Einstellen des einstellbaren Phasenschiebers (41) des Messabschnitts (4), derart, dass die zusätzliche Anregungskraft ($F_{pa}$), die von der externen Vorrichtung (5) auf den Resonator (1) ausgeübt wird, in Phasenquadratur in Bezug auf die Anregungskraft ($F_x$) ist, die von dem elektrischen Rückkopplungsabschnitt (2) ausgeübt wird;
/4/ Messen einer Verschiebung der Resonanzfrequenz ($f_r$) des Oszillators (10), die aus der zusätzlichen Anregungskraft ($F_{pa}$) resultiert; und
/5/ Abziehen eines Wertes der Gaskonzentration basierend auf der gemessenen Verschiebung für die Resonanzfrequenz ($f_r$).

**9.** Verfahren nach Anspruch 8, wobei der Wert der Gaskonzentration aus der Verschiebung der Resonanzfrequenz ($f_r$) im Schritt /5/ nach der folgenden Formel abgeleitet wird:

$$C_{gaz} = [3 \cdot Q \cdot N_x \cdot V_x / (4 \cdot \beta \cdot f_r)] \cdot \Delta f_r$$

wobei Q und $f_r$ jeweils ein Qualitätsfaktor und eine Eigenfrequenz der Schwingung des elektromechanischen Resonators (1) sind, $N_x$ ein piezoelektrischer Umwandlungsfaktor des elektromechanischen Resonators ist, $V_x$ eine Anregungsspannungsamplitude des elektromechanischen Resonators ist und $\beta$ eine von der Gaskonzentration unabhängige konstante Zahl ist.

10. Verfahren nach Anspruch 8 oder 9, wobei Schritt /3/ die folgenden Unterschritte umfasst:

- Messen einer Frequenz des Oszillators (10) in Echtzeit während eines Betriebs des Gasdetektors; und
- Einstellen des einstellbaren Phasenschiebers (41) des Messabschnitts (4), derart, dass die genannte gemessene Oszillatorfrequenz ein Maximum ist.

11. Verfahren nach einem der Ansprüche 8 bis 10, wobei der Resonator (1) eine Stimmgabel umfasst, und wobei der einstellbare Phasenschieber (41) in Schritt /3/ dazu eingestellt wird, eine Phasenverschiebung zu erzeugen, gleich:

$$\frac{\pi}{2} - Arctan\left(2\pi f_r \tau_{V-T}\right) - Arctan\left(\frac{\int_{-\frac{l}{2}}^{\frac{l}{2}}\left[Y_0\left(\frac{2\pi f_r}{c}r_{in}\right) - Y_0\left(\frac{2\pi f_r}{c}r_{ext}\right)\right]dz}{\int_{-\frac{l}{2}}^{\frac{l}{2}}\left[J_0\left(\frac{2\pi f_r}{c}r_{in}\right) - J_0\left(\frac{2\pi f_r}{c}r_{ext}\right)\right]dz}\right)$$

où $r_{in} = \left[\left(\frac{L}{2}\right)^2 + (z-H)^2\right]^{\frac{1}{2}}$ et $r_{ext} = \left[\left(\frac{L}{2}+e\right)^2 + (z-H)^2\right]^{\frac{1}{2}}$ wobei Oz eine Achse parallel zu einer Längsrichtung der Schenkel der Stimmgabel ist, mit einem Ursprungspunkt, der sich an einem Fuß der Schenkel befindet, H ein erster Abstand ist, der parallel zur Oz-Achse zwischen dem Fuß der Schenkel der Stimmgabel und einem Zentrum des Strahlungsstrahls (FX) gemessen wird, der von dem modulierbaren Laser stammt, L ein zweiter Abstand ist, der senkrecht zur Oz-Achse zwischen dem Zentrum des Strahlungsstrahls und der Stimmgabel gemessen wird, e eine Dicke der Schenkel der Stimmgabel ist, gemessen parallel zur zweiten Strecke L, c eine Ausbreitungsgeschwindigkeit des Schalls im Gas ist, $f_r$ die Eigenfrequenz der Schwingung des elektromechanischen Resonators ist, $\tau_{V-T}$ eine Relaxationszeit des Gases ist und $J_0$ und $Y_0$ Bessel-Funktionen erster Ordnung der ersten bzw. zweiten Art sind.

## Claims

1. A gas detector comprising:

- an electrical measurement circuit, said electrical measurement circuit comprising:

- an electromechanical resonator (1);
- a feedback electrical branch (2), having an input (2a) which is connected to a detection terminal (1b) of the resonator (1) for receiving a response signal from said resonator, and an output (2b) which is connected to an excitation terminal (1a) of the resonator for applying an excitation force ($F_x$) to said resonator, so that the resonator and the feedback electrical branch form at least a part of an oscillator (10) operating at a resonant frequency (fr);
- a frequency measurement device (3) connected to the oscillator (10) so as to measure the resonant frequency ($f_r$); and
- a measurement branch (4), having an input (4a) connected to the output (2b) of the feedback electrical branch (2), and a modulation output (4b) adapted for transmitting a modulation signal to an external device (5), depending on an excitation signal which exists at the output (2b) of the feedback electrical branch (2),

so that when the external device (5) is adapted for applying an additional excitation force ($F_{pa}$) to the resonator (1), in addition to the excitation force ($F_x$) applied by the feedback electrical branch (2), then an offset of the resonant frequency ($f_r$), which is measured by the frequency measurement device (3) and which results from the additional excitation force, constitutes a measurement of a parameter of the external device (5), the gas detector further comprising:

- a tunable laser constituting the external device (5) with the modulation output (4b) of the measurement branch (4) connected to a modulation input of the tunable laser, and where said tunable laser is oriented so that a gas which would have an absorption line corresponding to a wavelength of the tunable laser and which would receive a radiation beam (FX) originating from said tunable laser, produces an acoustic wave and said acoustic wave produces the additional excitation force ($F_{pa}$) onto the resonator(1),

so that the parameter which is measured by the offset of the resonant frequency ($f_r$) is a concentration of the gas which has an absorption line at the wavelength of the tunable laser,
the gas detector being **characterized in that** the measurement branch (4) of the electrical measurement circuit comprises an adjustable phase shifter (41) which is arranged between the input (4a) and the modulation output (4b) of said measurement branch, so that a phase shift of the additional excitation force ($F_{pa}$) which is applied by the external device (5) to the resonator (1) is tunable, in order that said additional excitation force is in phase quadrature relative to the excitation force ($F_x$) which is applied by the feedback electrical branch (2).

2.  The gas detector according to claim 1, wherein the resonator (1) of the electrical measurement circuit is of the vibrating quartz element type, for example the quartz tuning fork type, or of the vibrating silicon element type, for example the silicon tuning fork type.

3.  The gas detector according to claim 1 or 2, wherein the feedback electrical branch (2) of the electrical measurement circuit comprises an amplifier (21) and a phase shifter (22) which are combined in series, or comprises a phase-locked loop assembly.

4.  The gas detector according to any one of claims 1 to 3, wherein the measurement branch (4) of the electrical measurement circuit is adapted for reversibly applying an additional phase shift equal to pi, in addition to the phase shift which is tunable by means of the adjustable phase shifter (41),
    so that the offset of the resonant frequency ($f_r$) which constitutes the measurement of the parameter of the external device (5) is equal to half of a difference between two values which are measured for the resonant frequency ($f_r$) with and without, respectively, the additional phase shift equal to pi.

5.  The gas detector according to any one of claims 1 to 3, wherein the electrical measurement circuit further comprises:

    - a reference electromechanical resonator; and
    - another feedback electrical branch, having an input connected to a detection terminal of the reference resonator for receiving a response signal from said reference resonator, and an output connected to an excitation terminal of the reference resonator for applying another excitation force to said reference resonator, so that the reference resonator and said another feedback electrical branch form a reference oscillator ($10_{ref}$) operating at another resonant frequency, called reference frequency ($f_{ref}$), independently of the oscillator (10) which is connected to the measurement branch (4);

    and the measurement electrical circuit is further adapted for measuring the reference frequency ($f_{ref}$) separately from the resonant frequency ($f_r$) of the oscillator (10) which is connected to the measurement branch (4), so that the offset of the resonant frequency ($f_r$) which constitutes the measurement of the parameter of the external device (5) corresponds to a difference between the resonant frequency ($f_r$) which is measured for the oscillator connected to the measurement branch and the reference frequency.

6.  The gas detector according to any one of the preceding claims, wherein the tunable laser is tunable in wavelength or radiation power for the radiation beam (FX) which originates from said tunable laser.

7.  The gas detector according to any one of the preceding claims, wherein the resonator (1) comprises a tuning fork, and the tunable laser is oriented so that the radiation beam (FX) which originates from said tunable laser is perpendicular to two tines of the tuning fork, and passes between the two tines of the tuning fork in a symmetry plane of said tuning fork, or passes on one side of one of the two tines of the tuning fork which is opposite from the other tine of said tuning fork.

8.  A method for measurement of a concentration of a gas, comprising the following steps:

    /1/ selecting a gas detector which complies with any one of the preceding claims, and for which a wavelength of the tunable laser corresponds to an absorption line of the gas;
    /2/ arranging the gas detector so that the radiation beam (FX) which originates from the tunable laser passes through a zone which may contain a quantity of the gas;

/3/ adjusting the adjustable phase shifter (41) of the measurement branch (4), so that the additional excitation force ($F_{pa}$) applied by the external device (5) to the resonator (1) is in phase quadrature relative to the excitation force ($F_x$) which is applied by the feedback electrical branch (2);

/4/ measuring an offset of the resonant frequency ($f_r$) of the oscillator (10), resulting from the additional excitation force ($F_{pa}$); and

/5/ deducing a value of the gas concentration from the measured offset of the resonant frequency ($f_r$).

9. The method according to claim 8, wherein the value of the gas concentration is deduced from the offset of the resonant frequency ($f_r$), in step /5/, by using the formula:

$$C_{gas} = [3 \cdot Q \cdot N_x \cdot V_x / (4 \cdot \beta \cdot f_r)] \cdot \Delta f_r$$

where Q and $f_r$ are respectively a quality factor and a vibration eigenmode frequency of the electromechanical resonator (1), $N_x$ is a piezoelectric conversion factor of said electromechanical resonator, $V_x$ is an excitation voltage amplitude of said electromechanical resonator, and $\beta$ is a constant number which is independent of the concentration of the gas.

10. The method according to claim 8 or 9, wherein step /3/ comprises the following sub-steps:

- measuring in real time a frequency of the oscillator (10) during an operation of the gas detector; and
- setting the adjustable phase shifter (41) of the measurement branch (4) so that said frequency of the oscillator as measured is maximum.

11. The method according to any one of claims 8 to 10, wherein the resonator (1) comprises a tuning fork, and wherein the adjustable phase shifter (41) is adjusted in step /3/ to produce a phase shift which is equal to:

$$\frac{\pi}{2} - Arctan\left(2\pi f_r \tau_{V-T}\right) - Arctan\left(\frac{\int_{-\frac{l}{2}}^{\frac{l}{2}}\left[Y_0\left(\frac{2\pi f_r}{c}r_{in}\right) - Y_0\left(\frac{2\pi f_r}{c}r_{ext}\right)\right]dz}{\int_{-\frac{l}{2}}^{\frac{l}{2}}\left[J_0\left(\frac{2\pi f_r}{c}r_{in}\right) - J_0\left(\frac{2\pi f_r}{c}r_{ext}\right)\right]dz}\right)$$

where $r_{in} = \left[\left(\frac{L}{2}\right)^2 + (z-H)^2\right]^{\frac{1}{2}}$ and $r_{ext} = \left[\left(\frac{L}{2}+e\right)^2 + (z-H)^2\right]^{\frac{1}{2}}$ where Oz is an axis parallel to a longitudinal direction of tines of the tuning fork with an origin which is located at a base of the tines, H is a first distance measured parallel to the axis Oz between the base of the tines of the tuning fork and a center of the radiation beam (FX) which originates from the tunable laser, L is a second distance measured perpendicularly to the Oz axis between said center of the radiation beam and the tuning fork, e is a thickness of the tines of the tuning fork measured parallel to the second distance L, c is a propagation speed of sound in the gas, $f_r$ is the vibrational eigenmode frequency of the electromechanical resonator, $\tau_{V-T}$ is a relaxation time of the gas, and $J_0$ and $Y_0$ are first-order Bessel functions of respectively the first and second kind.

FIG. 1

1a, 4a

signal
d'excitation

2b

2

REACTION

1b

signal de
réponse

| VCO | PI | | COMP. PHASE |
26  25  24  23

2a

FIG. 2

**FIG. 3a**

**FIG. 3b**

EP 3 523 644 B1

FIG. 4

signal de
modulation

51
MOD.

52
LASER

FX ( gaz ) onde
acoustique

1
RESON.

signal de
réponse

30
DETECT. SYNCHR.

## FIG. 5
(ART ANTÉRIEUR)

signal de mesure

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7245380 B
- WO 2009109897 A
- US 20110179872 A

**Littérature non-brevet citée dans la description**

- **LI M. ; SONMEZOGLU S. ; HORSLEY D.** Extended bandwidth Lorentz force magnetometer based on quadrature frequency modulation. *Journal of Microelectromechanical Systems,* 2015, vol. 24 (2), 333-342
- **T.L. COTTREL ; J. MCCOUBREY.** Molecular Energy Transfer in Gases. Butterworths, 1961, 64